# EUROPEAN PATENT SPECIFICATION

(11) **EP 2 782 151 B1**
(45) Date of publication and mention of the grant of the patent: **30.03.2016**
(21) Application number: 12847374.1
(22) Date of filing: 07.11.2012
(51) Int. Cl.: H01L 35/00, H01L 35/30, H01L 35/32

(54) **ELECTRICITY GENERATOR**
STROMGENERATOR
GÉNÉRATEUR ÉLECTRIQUE

(30) Priority: 08.11.2011 ES 201131153
(43) Date of publication of application: 24.09.2014
(73) Proprietor: POWERSPOT, S.L., 28002 Madrid (ES)
(72) Inventor: PASCUAL Diaz, Franisco Javier, 28002 Madrid (ES)
(74) Representative: Carlos Hernando, Borja
(86) International application number: PCT/ES2012/070772
(87) International publication number: WO 2013/068623

(56) References cited:
- EP-A1- 2 320 383
- EP-A2- 2 317 577
- WO-A1-01/80325
- CN-U- 201 708 191
- ES-A1- 2 323 931
- ES-U- 1 061 083
- ES-U- 1 073 131
- JP-A- 2002 136 160
- US-A- 3 082 276
- US-A1- 2010 083 946
- US-A1- 2011 284 047
- US-A1- 2012 153 636

## Description

### Object of the Invention

The present invention relates to an electric generator which allows carrying out the application of the Seebeck effect on heat energy sources on a small scale, obtaining an output voltage which can be used for powering portable electronic devices in a simple and intuitive manner or light sources in areas where the connection thereof to the power grid is impossible.

The object of the invention consists of a portable electric generator comprising a heating plate and cooling means between which there is arranged at least one thermoelectric plate where the electric current generated between the heating plate and the cooling means when the plate is at a temperature greater than that of the cooling means is collected, a potential difference being established as a result.

### Background of the Invention

Phenomena associated with electricity generation by means of applying heat to the junction of two different materials are known in the state of the art. If two wires made of different materials are attached at both ends and one of the junctions is kept at a temperature greater than the other, a voltage difference occurs causing an electric current to flow between the hot and cold junctions. This is the known Seebeck effect.

This effect is applicable in large installations that harness a large amount of waste heat energy to obtain a voltage difference which is used to power different devices.

Prior art devices such as those known from US 3 082 276 and US 2010/0083946 allow carrying out the application of this effect on heat energy sources on a small scale, obtaining an output voltage which can be used for feeding portable electronic devices in a simple and intuitive manner or light sources in areas where the connection thereof to the power grid is impossible.

### Description of the Invention

The present invention relates to an electric generator according to claim 1 comprising a heating plate transmitting heat to cooling means, and at least one thermoelectric plate arranged between the heating plate and the cooling means where an electromotive force generating an electric current is produced when the heating plate, located on an external heat source, is at a temperature greater than that of the cooling means, comprising insulating means surrounding the at least one thermoelectric plate and arranged between the heating plate and the cooling means, wherein the thermoelectric plate comprises wiring at the free end of which an electric potential output terminal for the output of electric potential generated in said plate is located, said wiring exiting the generator going through the cooling means without being exposed to the external heat source, characterized in that arranged on the heating plate there is an upper plate forming the lower base of a container where the cooling means are arranged, said container comprising a closing lid of the container determining a closed space for storing he wiring when the generator is not in use.

Said insulating means are preferably an element or air column that withstands temperatures of up to 1500°C, such as ceramic plates, such that they insulate the heat of the heating plate and prevent the heat from reaching the cooling means to avoid overheating said cooling means.

When the insulating means are air, the heating plate is thicker than other constructions object of the present invention, such that the greatest heat dissipation occurs in said heating plate and the thermoelectric plate is prevented from reaching temperatures greater than 400°C.

The cooling means can be different, preferably a liquid, for which purpose the generator has a container the base of which is an upper plate located on the thermoelectric plate or plates; a fan fed by the electric current generated by the generator itself; or a conductor plate.

For operation and electric power generation, the generator is arranged on an external heat source that acts on the heating plate which, in combination with the cooling means, cause an electromotive force generating an electric current due to the temperature difference produced by the thermoelectric plate or plates. In the event that the cooling means are liquid means, preferably water, it is necessary for the container to maintain a minimum liquid level to make the temperature difference possible and to prevent the thermoelectric plate or plates from burning. Therefore, in this case and taking into account that the liquid evaporates due to the heating thereof, it is necessary to provide the generator with liquid feeding means which can be automatic or manual in order to maintain the minimum liquid level.

The device can have a handle supporting the heating plate and the thermoelectric plate and further comprises an electric potential output terminal for the output of electric potential generated in the thermoelectric plate connected with said plate by means of wiring running through the inside of the handle.

Alternatively, instead of going out through the mentioned handle, the wiring of the thermoelectric plate or plates goes through the upper plate, passing through the container intended for containing the cooling means. The wiring is duly insulated and the connections are leak-tight to prevent contact with the cooling means which are preferably water. An electric potential output terminal for the output of electric potential generated in the thermoelectric plate or plates is arranged at the end of said wiring. Said terminal can be a lighter-type terminal, or a voltage divider-type terminal for USB, or any other known terminal. Since the wiring passes through the container containing the cooling means, the contact of said wiring with the external heat source on which the heating plate of the generator is supported is prevented and at the same time the overheating of the cable is prevented as it is cooled by the cooling means.

As mentioned, the cooling means can also consist of a fan connected to the thermoelectric plate or plates of the generator and arranged on the thermoelectric plate or plates. This construction also comprises wiring for the exit of the remaining electric potential not used by the fan through a handle.

In another alternative construction, the container formed on the upper plate has at least one hole for the entry or exit of the cooling means, specifically liquid means, and preferably water. It is possible to connect tubing to said hole for liquid circulation. The container preferably has two holes, one for entry and another for exit, thus enabling liquid recirculation and therefore allowing different applications using the recirculated liquid contained in the container. By combining the generator with a pump it is possible to recirculate the water, extracting the hot water to be used as heating in a radiator and driving it again towards the container once it goes through same so that it is again heated and keeps the circuit closed. Both electric power and a hot water source are obtained by means of this construction.

On the other hand, the electric generator can comprise a baffle plate arranged on the side of the heating plate opposite the side on which the thermoelectric plates are arranged and which allows partially insulating the heating plate from a heat source so that said heating plate does not exceed a predetermined temperature.

The electric generator can also comprise temperature control means which emit an acoustic signal or insulate the heating plate from the heat energy source when said heating plate reaches a predetermined temperature.

These devices are of special use in places where there is no power supply or where the power supply is unreliable, mainly in remote locations in underdeveloped or developing countries, and in which a device such as the one of the present invention will allow obtaining enough electric power for lighting purposes, for charging small electric devices (mobile telephones, batteries, ipads, ipods, etc.), or even for heating water used even for heating purposes.

### Description of the Drawings

To complement the description that is being made and for the purpose of aiding to better understand the features of the invention according to a preferred practical embodiment thereof, a set of drawings is attached as an integral part of said description in which the following has been depicted with an illustrative and non-limiting character:
Figure 1 shows an elevational section view of a first embodiment of the electric generator of the present invention.
Figure 2 shows a partially sectioned elevational view of a second embodiment of the electric generator of the present invention.
Figure 3 shows a plan view of the electric generator of Figure 2.
Figure 4 shows an AA section view of Figures 2 and 3.
Figure 5 shows an exploded perspective view of the electric generator of Figure 2.
Figure 6 shows an exploded perspective view of a third embodiment of the electric generator of the present invention.
Figure 7 shows a section view of a fourth embodiment of the invention of a generator cooled with a liquid.
Figure 8 shows a perspective view of Figure 7.
Figure 9 shows a plan view of the example of Figures 7 and 8 in which the generator is seen open.
Figure 10 shows a section view of a fifth embodiment of the invention of a generator cooled with a liquid.
Figure 11 shows a perspective view of the example of Figure 9.
Figures 12a and 12b show a plan view and a section of the heating plate used in the embodiment of Figures 10 and 11.

### Preferred Embodiments of the Invention

In view of the drawings, different preferred embodiments of electric generators of the present invention are described below, said electric generators comprising a circular heating plate (7) and cooling means (10, 26) between which at least one thermoelectric plate (15) is arranged, and if there is more than one heating plate, such heating plates are arranged in series, where the electric current generated between the heating plate (7) and the cooling means (10, 26) when the heating plate (7) is at a temperature greater than that of the cooling means (10, 26) due to the contact with a heat source is collected, a potential difference being established as a result.

In a first embodiment, the circular heating plate (7) has a perimetral wall (16) and a central projection (20) between which a hollow is defined where there are arranged insulating means (8), which are a paper disc or a fireproof plate made of ceramic fiber that withstands temperatures up to 1500°C. In this embodiment, the generator has four thermoelectric plates (15) arranged in series.

The insulating means (8) insulate the unneeded heat of the heating plate (7) to prevent it from overheating an upper plate (21) forming the base of a container (22) where the cooling means are arranged, in this embodiment, the cooling means are water (26) arranged inside said container (22). Likewise, the insulating means (8) electrically and thermally insulate the cables of the thermoelectric plates (15). A heat-conducting silicone or resin layer (23) is arranged on said thermoelectric plates (15).

A deformable ring or gasket (24) made of fireproof material is arranged on the perimetral wall (16) of the heating plate (7) such that the height of the heating plate (7) plus the height of the deformable ring (24) in the area of the perimetral wall (16) is the same as the height of the heating plate (7) plus the height of the thermoelectric plates (15) plus the height of the heat-conducting silicone or resin layer (23) in the area of the central projection (20).

A baffle plate (9) which prevents the circular heating plate (7) from melting in the event that the heat source is at a high temperature is arranged below the heating plate (7). The electric generator further comprises temperature control means comprising bimetallic rods (17) attached at one of their ends to the baffle plate (9) and at the other end to the circular heating plate (7), insulating the circular heating plate (7) from a heat energy source when a predetermined temperature, in this case 100°C, is exceeded.

The container (22) comprises a handle (27) with a hole (28) for the passage of the connection cables of the thermoelectric plates (15), at the end of which handle an electric potential output terminal (29) of the 12-V lighter-type is coupled.

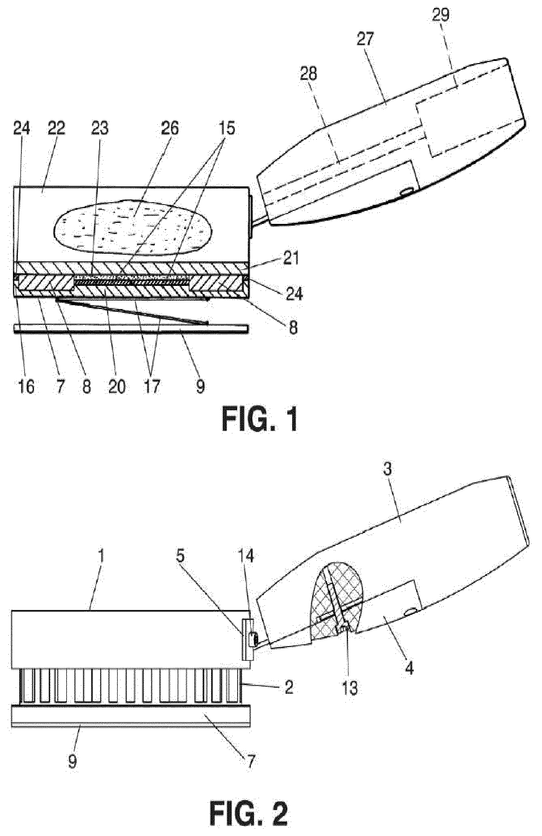

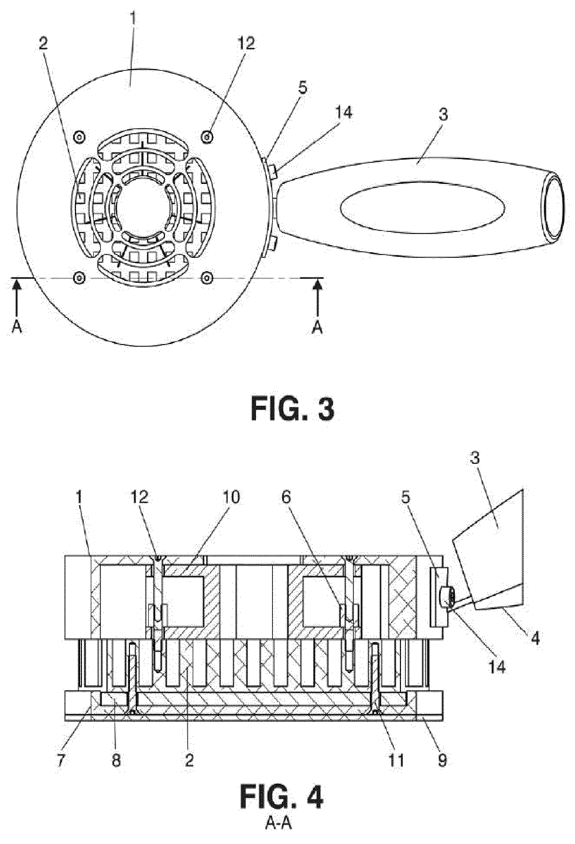

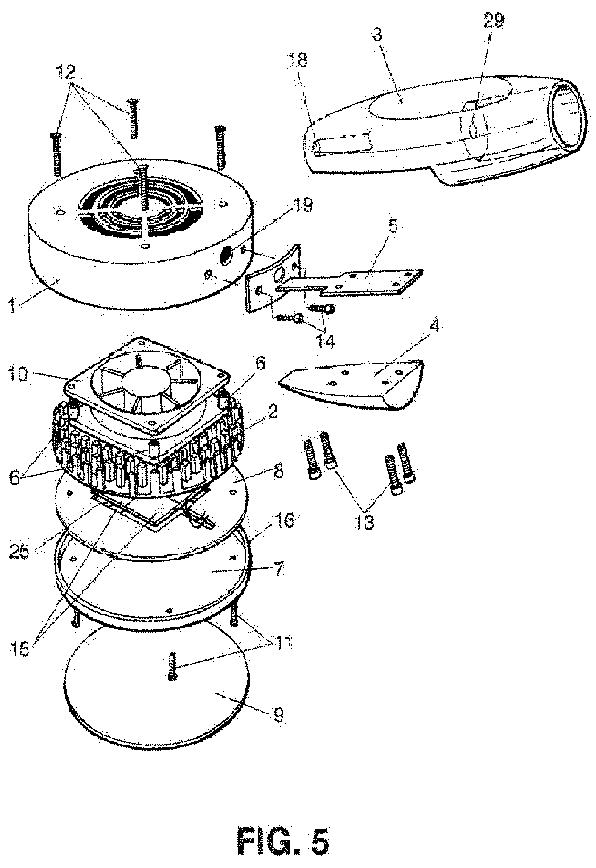

In a second embodiment shown in Figures 2 to 5, the circular heating plate (7) has a perimetral wall (16) defining a hollow where there are arranged insulating means (8), which are a paper disc or a fireproof plate made of ceramic fiber that withstands temperatures up to 1500°C, and the thermoelectric plates (15), which are arranged in a central hole (25) of the insulating means (8). The insulating means (8) are thus radially arranged between the thermoelectric plates (15) and the perimetral wall (16).

The insulating means (8) insulate the unneeded heat of the heating plate (7) to prevent it from overheating the elements which are arranged thereon and which will be described below, and they electrically and thermally insulate the cables of the thermoelectric plates (15). A heat-conducting silicone or resin layer (not shown in Figures 2 to 5) is arranged on the thermoelectric plates (15).

An aluminum sink (2) having a polished lower mirror surface and with grid fins to discharge the heat coming from the heating plate (7) is arranged on the assembly formed by the circular heating plate (7), the insulating means (8) and the thermoelectric plates (15). The cables of the thermoelectric plates (15) pass through the sink (2).

There are arranged on the sink (2) cooling means which in this preferred embodiment are a fan (10) which is connected to the wiring of the thermoelectric plates (15) and works at the same voltage as that obtained from the potential output terminal, which is 12 V and at a current of 0.2 A, and is activated when the current generated as the generator starts heating up reaches 2.2 V. The connections of the thermoelectric plates (15) to the cables are arranged on the fins of the sink (2) (not shown) and at the sides of the fan. The electric generator comprises a digital voltmeter powered by the actual current obtained by the thermoelectric plates (15). This example may have a handle (3) for the exit of the wiring or, in contrast, it may not have a handle such that all the power generated by the generator is allocated for powering the fan, such that the device is converted into a hot air diffuser as it can be located on heat sources and be limited to distributing heat in the room where it is used.

The circular heating layer (7) is screwed to the sink (2) through first screws (11) arranged in the holes of the heating layer (7), of the insulating means (8) and of the sink (2).

A baffle plate (9) which prevents the circular heating plate (7) from melting in the event that the heat source is at a high temperature is arranged below the circular heating plate (7).

The electric generator further comprises temperature control means comprising a buzzer (not shown) connected to a thermostat (not shown) which emits an acoustic signal when said heating plate (7) reaches a predetermined temperature, or bimetallic rods (not shown in Figures 2 to 5) attached at one of their ends to the baffle plate (9) and at the other end to the circular heating plate (7), insulating the circular heating plate (7) from a heat energy source when a predetermined temperature, in this case 100°C, is exceeded.

A lid (1) made of sheet metal or aluminum with holes having dimensions suitable for the fan to take in air and at the same time for preventing the accidental entry of foreign objects, particularly human fingers, is arranged on the sink (2) and covering the fan. The lid (1) is attached to the fan and to the sink (2) through second screws (12) and spacers (6).

A light bulb socket (not shown) for lighting a light bulb when current starts to be generated, a power, pilot or positional LED, or any presence-indicating light source, is arranged on the center of the lid (1). The generator also has a switch in the event that this source is to be cut off and a larger load is to be obtained from the 12-V socket.

The electric current is extracted from the thermoelectric plates (15) by means of the conductor cables which are connected to an electric potential output terminal (29) of the 12-V lighter-type (not shown), arranged in a handle attached to the lid (1). The handle comprises a main body (3), a structure (5) that attaches the handle to the lid (1) and a closure cover (4) fixing the structure (5) that attaches the handle to the lid (1) to the main body (3). This fixing is carried out by means of third screws (13). The structure (5) that attaches the handle to the lid (1) is attached to said lid (1) by means of fourth screws (14).

The main body (3) of the handle comprises a hole (18) for the passage of the connection cables which emerge through a perimetral hole (19) of the lid (1) and are connected to a potential output terminal (29) of the 12-V lighter-type.

The socket for a user is therefore located away from the heating plate (7), which allows the connection of 12-V extensions, voltage dividers for USB and 220-V power inverters.

The electric generator of this second preferred embodiment provides 20 V and 2 A when there is no load and 12-V and 1.6 A when loaded, which allows lighting a low consumption 15-W neon light bulb (equal to 75 W of incandescence) or a 10-W light bulb and at the same time as lighting the light bulb, charging a battery charger, a mobile telephone charger, or other electronic devices such as ipods or ipads. At the same time, it can light up to 5 3-W LED light bulbs (each one equal to 75 W of incandescence) or any apparatus powered through a USB port.

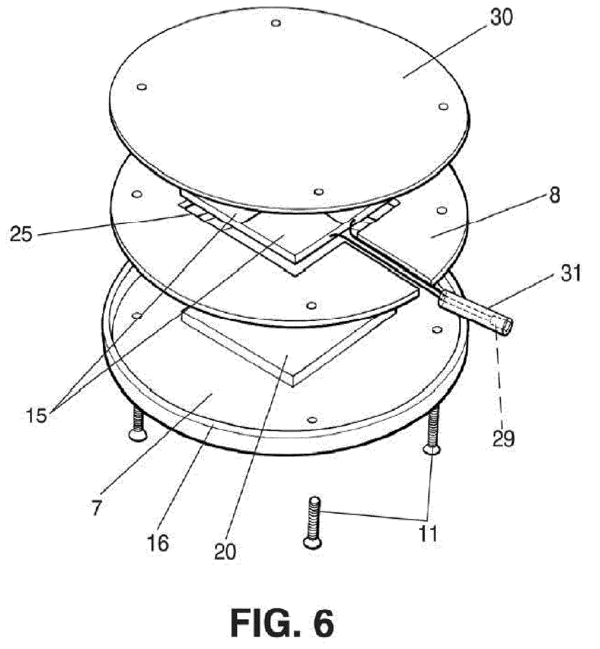

In a third embodiment shown in Figure 6, the circular heating plate (7) has a perimetral wall (16) defining a hollow with the central projection (20) in which the thermoelectric plate (15) is located, in which hollow there are arranged insulating means (8), which are a paper disc or a fireproof plate made of ceramic fiber that withstands temperatures up to 1500°C, and the thermoelectric plates (15), which are arranged in a central hole (25) of the insulating means (8). The insulating means (8) are thus radially arranged between the thermoelectric plates (15) and the perimetral wall (16). A conductor plate (30) acting as cooling means is arranged on the insulating means (8) and the thermoelectric plates (15).

The cables of the thermoelectric plates (15) can be connected to an electric potential output terminal (29) of the 12-V lighter-type or voltage divider-type for USB arranged in a flexible protective fireproof sheath (31).

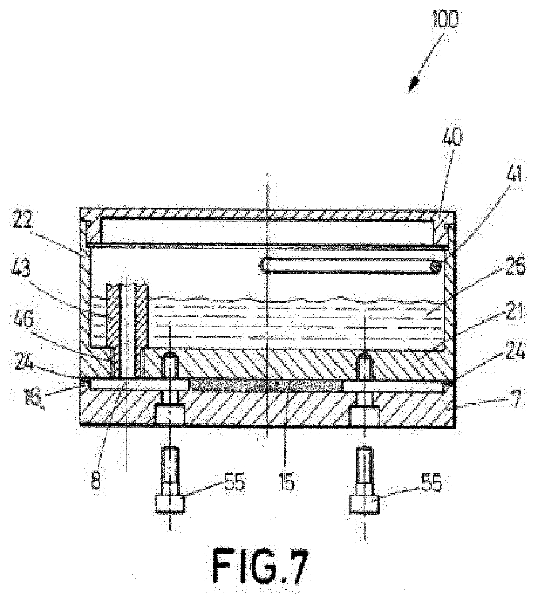

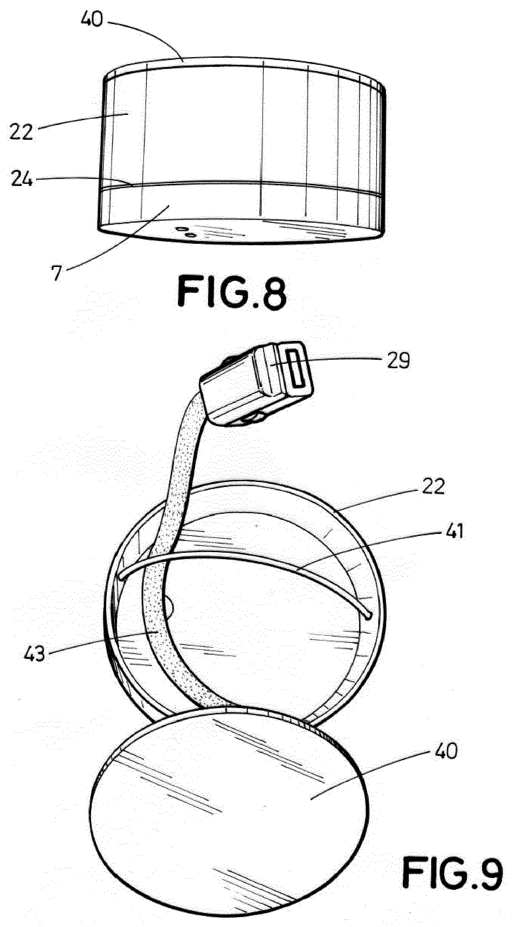

In a fourth embodiment shown in Figures 7 to 9, the electric generator (100) comprises a circular heating plate (7) with a perimetral wall (16) on which a thermoelectric plate (15) is arranged preferably attached to the upper surface of the heating plate (7) by means of an adhesive to facilitate assembly, and air preferably acting as the insulating means (8) between the thermoelectric plate (15) and the perimetral wall (16). It is also possible to use two thermoelectric plates connected in series, for which purpose insulating and fireproof elements are used in the connection of the cables between plates (15) to prevent said wiring from contacting the material of the generator. As in the preceding cases, the insulating means can also be a ceramic plate or a suitable gas. The upper plate (21) representing the lower base of the container (22) in which the cooling means (26) of the generator (100), preferably water, are introduced, is located on the thermoelectric plate (15) and supported on the perimetral wall (16). A fireproof and deformable ring or gasket (24) is arranged between the upper plate (21) and the perimetral wall (16). The container (22) is secured to the heating plate (7) by means of screws (55) that go through the heating plate (7) to the upper plate (21), which is the lower base of the container (22). Said container comprises at its upper base, opposite the upper plate (21) or lower base of the container (22), a grip (41) which allows transporting the generator (100). It also comprises a lid (40) which is arranged on said upper base of the container (22). The heating plate (7) is attached to the upper plate (21) preferably by means of screws (55).

After the device is assembled, said thermoelectric plate or plates (15) are in direct contact with the upper surface of the heating plate (7) and with the lower surface of the upper plate (21), pressed between them, said contact surfaces of the heating plate (7) and of the upper plate (21) being polished mirror surfaces.

The wiring or cables coming out of the thermoelectric plate (15) run between the heating plate (7) and the upper plate (21). Said upper plate (21) has a threaded hole (46) connecting with a flexible, insulating and leak-tight conduit or sheath (43) which is screwed into the threaded hole (46) of the upper plate (21). The coupling between the conduit (43) and the threaded hole (46) of the plate is leak-tight. The wiring of the thermoelectric plate (15) comes out from inside the generator (100) through the inside of the conduit (43), being connected to an electric potential output terminal (29) of the 12-V lighter-type or voltage divider-type for USB. When the generator (100) is not in use, it is possible to store the conduit or sheath (43) inside the container (22) and close same with the lid (40), which is preferably screwed onto the container (22).

Therefore, the generated electricity is extracted from the generator (100) going through the cooling means (26), preventing the wiring from being exposed to the heat source on which the generator (100) is arranged and thus preventing said wiring from being overheated. As mentioned, said sheath (43) is leak-tight and fireproof and comprises sealing gaskets at the ends.

All the components of the generator (100) of this embodiment are preferably manufactured in aluminum, said parts being anodized for the purpose of protecting the material from oxidation. The thickness of the upper plate (21), which is the cold plate of the device, preferably has a thickness between 7 and 10 mm, and the heating plate (7) preferably has a thickness between 8 and 12 mm. These thicknesses, along with the material, allows using air instead of other elements as the insulating means (8), since a plate having such thickness allows better and greater heat dissipation, preventing the temperature of the thermoelectric plate from exceeding the limit use temperature of 400°C.

Compared with other constructions, the generator object of this example has the advantages of weighing less, about 535 grams, since components such as a sink or fan are not included, of being more compact due to its smaller size, more robust due to the non-existence of moving components preventing repairs, and all the power generated is allocated for being used by external elements and not for powering the components themselves, such as the fan.

Once the different components are assembled, a generator (100) as described in this last embodiment preferably has a height of 48 mm and a diameter of 100 mm. The lid (40) has a height of 8 mm. The thermoelectric plates (15) that are used have dimensions of 40 mm x 40 mm.

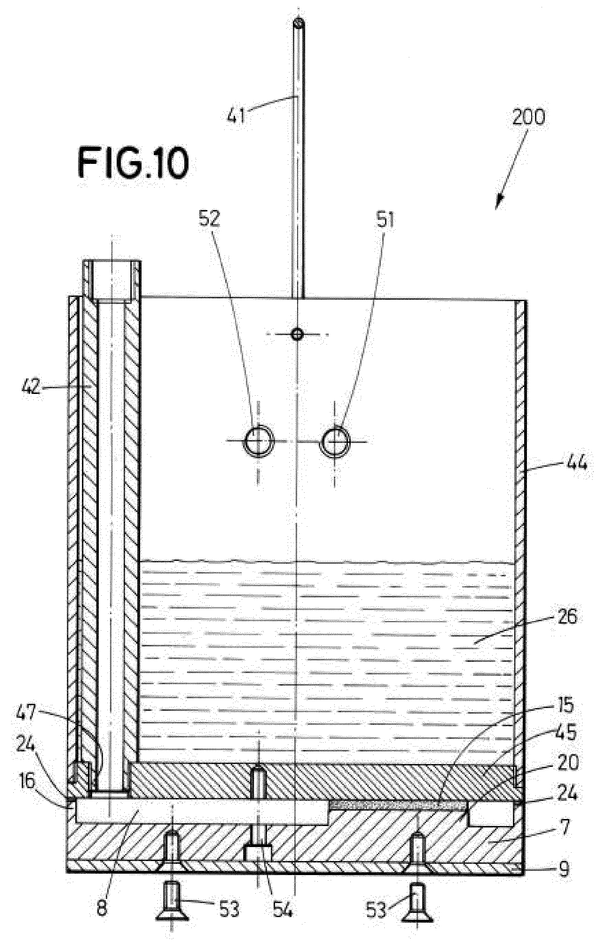

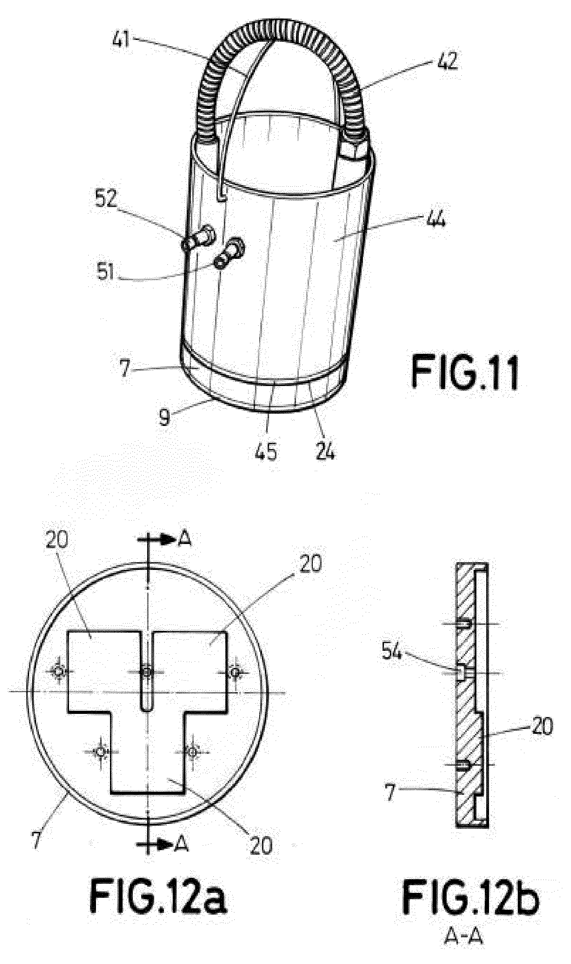

In a fifth and last embodiment of the present invention, Figures 10 to 12, as in the preceding example, the generator (200) comprises a circular heating plate (7) with a perimetral wall (16), said plate (7) having three projections (20) on its upper surface to increase the distance between the thermoelectric plates (15) with respect to the heat source since a thermoelectric plate (15) preferably attached with an adhesive to facilitate assembly is arranged on each projection (20), the air acting as insulating means (8) between the thermoelectric plates (15) and the perimetral wall (16). As in the preceding case, the insulating means (8) can be a ceramic plate. Said thermoelectric plates (15) are connected in series and their connection points are covered by an insulating and fireproof material which prevents the cables from contacting the material of the generator (200).

The upper plate (45) representing the lower base of the container in which the cooling means (26) of the generator (200), preferably water, are introduced, is located on the thermoelectric plates (15) and supported on the perimetral wall (16). A fireproof and deformable ring or gasket (24) is arranged between said perimetral wall (16) and the upper plate (45). Said container can be formed as a single part or, as shown in the drawings, it can be formed by a cylindrical wall (44) screwed to the upper plate (45) representing the lower base of the container. A baffle plate (9) made of stainless steel which prevents the circular heating plate (7) from melting in the event that the heat source is at a temperature can be arranged below the heating plate (7). Although this baffle plate (9) is not strictly necessary and will depend on the conditions of use of the generator (200), it allows prolonging the service life of the heating plate (7) manufactured in aluminum which deteriorates with heat and oxygen.

The heating plate (7) is attached to the upper plate (45) preferably by means of screws (54), and if the generator (200) has a baffle plate (9), this is attached to the heating plate (7) also preferably by means of screws (53).

As in the preceding examples and as detailed in the preceding example, the thermoelectric plates (15) are in direct contact with and pressed between the upper surface of the heating plate (7) and the lower surface of the upper plate (45), these two surfaces being polished mirror surfaces.

The container (45, 44) is secured to the heating plate (7) by means of screws (54) that go through the heating plate (7) to the upper plate (45) representing the base of the container. The baffle plate (9) is secured to the heating plate (7) by means of screws (54).

Said container comprises in its upper base, opposite the upper plate (45) or lower base of the container, a grip (41) which allows transporting the generator (100). It also comprises two holes (51, 52) close to said upper base, although there could be only one hole. Said holes (51, 52) allow connecting tubings for extracting heated water, preventing the water from evaporating. By means of said recirculation, said hot water is used such that, for example, it can be recirculated to the container after passing through a radiator, in which case the wall of the container would have two holes (51, 52), one for the exit and another for the entry of water, or the hot water is only extracted for use in washing, for example. In this last case, only one hole would be necessary, so the wall of the container (44) can have a single hole or one of the two holes can be covered if it has two holes.

The wiring or cables coming out of the thermoelectric plates (15) run between the heating plate (7) and the upper plate (44). Said upper plate (21) has a threaded hole (47) connecting with a flexible conduit (42) which is screwed into the threaded hole (47) of the upper plate (44). Said flexible conduit (42) internally conducts the wiring coming from the thermoelectric plates (15), said wiring preferably being introduced in a leak-tight and fireproof sheath. Sealing gaskets are arranged at the ends of the conduit. The coupling between the conduit (42) and the threaded hole (47) of the plate (44) is leak-tight. The wiring of the thermoelectric plates (15) arranged in series comes out from inside the generator (200) through the inside of the conduit (42), being connected to an electric potential output terminal (29) of the 12-V lighter-type or voltage divider-type for USB.

Therefore, the generated electricity is extracted from the generator (200) going through the cooling means (26), preventing the wiring from being exposed to the heat source on which the generator (200) is arranged and thus preventing said wiring from being overheated.

As in the preceding example, all the components of the generator (200) of this embodiment are preferably manufactured in aluminum, except for the baffle plate (9) which is made of stainless steel, said parts being anodized for the purpose of protecting the material from oxidation. The thickness of the upper plate (21), which is the cold plate of the device, preferably has a thickness between 7 and 10 mm and the heating plate (7), or hot plate, preferably has a thickness between 8 and 12 mm. These thicknesses, along with the material, preferably allows using air instead of other elements as the insulating means (8), since a plate having such thickness allows better and greater heat dissipation, preventing the temperature of the thermoelectric plate from exceeding the limit use temperature of 400°C. It is also possible to use a ceramic plate as insulating means (8) if the conditions require it.

By means of the generator (200) of this last embodiment, it is possible to use the heated water of the cooling means (26) as well as to obtain electric power.

Compared to those described above, this generator (200) has the advantages of allowing greater autonomy, greater robustness since it lacks moving components, preventing repairs, recycling cooling water, using the water for heating and allocating all the generated power for use.

Once the different components are assembled, a generator (200) such as the one described in this last embodiment preferably has a height of 160 mm and a diameter of 130 mm. The thermoelectric plates (15) that are used have dimensions of 40 mm x 40 mm.

Compared with those described above, the last two generators (100, 200) generally have the advantage of the non-existence of moving components, which facilitates their maintenance and prolongs their life since possible assembly and use faults are reduced since the generators object of the invention are preferably ideal for use in remote places with limited energy resources and without means for repairing the generators. Therefore, these last generators are more compact and resistant as can be deduced from the preceding explanation.

In any case, and based on the different examples, the features thereof could be combined and applied between different generators for the purpose of carrying out specific applications depending on different needs. For example, a thermostat or temperature control device associated with a device which emits an acoustic or light signal can be arranged in any of the generators.

It must be pointed out that in generators which use water as the cooling element, it will be necessary to ensure that the container always has a minimum water level such that the operation of the generator is assured, and the thermoelectric plates are in turn prevented from being burned or damaged. Different means can be used to ensure said water supply, for example manual means, such that someone is responsible for maintaining the water level, or autonomous means, such as arranging a receptacle with water on the generator and regulating the supply of water from said receptacle.

## Claims

1. An electric generator comprising a heating plate (7) transmitting heat to cooling means (10, 26, 30), and at least one thermoelectric plate (15) arranged between the heating plate (7) and the cooling means (10, 26, 30) where an electromotive force generating an electric current is produced when the heating plate (7), located on an external heat source, is at a temperature greater than that of the cooling means (10, 26, 30), comprising insulating means (8) surrounding the at least one thermoelectric plate (15) and arranged between the heating plate (7) and the cooling means (10, 26, 30), wherein the thermoelectric plate (15) comprises wiring at the free end of which an electric potential output terminal (29) for the output of electric potential generated in said plate (15) is located, said wiring exiting the generator going through the cooling means (26) without being exposed to the external heat source, **characterized in that** arranged on the heating plate (7) there is an upper plate (21, 45) forming the lower base of a container (22, 44) where the cooling means (26) are arranged, said container (22, 44) comprising a closing lid (40) of the container (22, 44) determining a closed space to store the wiring when the generator is not in use.

2. Generator according to claim 1, **characterized in that** the heating plate (7) has a perimetral wall (16) defining a hollow between said wall and the thermoelectric plate (15) where the insulating means (8) are arranged.

3. The generator according to claim 2, **characterized in that** the heating plate (7) comprises at least one central projection (20) on which the thermoelectric plate (15) is arranged.

4. The generator according to claim 1, **characterized in that** the insulating means (8) are air surrounding the at least one thermoelectric plate.

5. The generator according to claim 1, **characterized in that** the cooling means are water (26).

6. The generator according to claim 1, **characterized in that** the cooling means are a conductor plate (30) arranged on the insulating means (8) and the thermoelectric plates (15).

7. The generator according to claim 1, **characterized in that** it comprises a heat-conducting silicone or resin layer (23) arranged on the thermoelectric plate (15).

8. The generator according to claim 2, **characterized in that** it comprises a deformable ring (24) made of fireproof material arranged on the perimetral wall (16) of the heating plate (7).

9. The generator according to claims 2 and 8, **characterized in that** the deformable ring (24), the insulating means (8) and the heat-conducting silicone or resin layer (23) are arranged between the heating plate (7) and the upper plate (21, 45).

10. The generator according to claim 1, **characterized in that** it comprises an aluminum sink (2) having a polished lower mirror surface and with grid fins arranged on the assembly formed by the heating plate (7), the insulating means (8) and the thermoelectric plates (15) to discharge the heat coming from the heating plate (7).

11. The generator according to claim 1, **characterized in that** the cooling means are a fan (10) connected to the wiring of the thermoelectric plates (15) which works at the same voltage as that obtained from the potential output terminal (29).

12. The generator according to claim 1, **characterized in that** the wall of the container (44) comprises at least one hole (51, 52) for the exit or entry of the cooling means (26).

## Patentansprüche

1. Elektrischer Generator umfassend eine Heizplatte (7), die Wärme zu Kühlmitteln (10, 26, 30) überträgt, und mindestens eine thermoelektrische Platte (15), die zwischen der Heizplatte (7) und den Kühlmitteln (10, 26, 30) angeordnet ist, wo eine elektromotorische Kraft produziert wird, die einen elektrischen Strom erzeugt, wenn die Heizplatte (7), die an einer externen Wärmequelle liegt, eine Temperatur hat, die höher als jene der Kühlmittel (10, 26, 30) ist, umfassend Isoliermittel (8), die die mindestens eine thermoelektrische Platte (15) umgeben und zwischen der Heizplatte (7) und den Kühlmitteln (10, 26, 30) angeordnet sind, wobei die thermoelektrische Platte (15) eine Verkabelung umfasst, an deren freiem Ende ein Ausgangsanschluss (29) eines elektrischen Potentials für den Ausgang des elektrischen Potentials, das in der Platte (15) erzeugt wird, liegt, wobei die Verkabelung den Generator durch die Kühlmittel (26) verlaufend verlässt, ohne der externen Wärmequelle ausgesetzt zu sein, **dadurch gekennzeichnet, dass** auf der Heizplatte (7) eine obere Platte (21, 45) angeordnet ist, die den unteren Boden eines Behälters (22, 44) bildet, wo die Kühlmittel (26) angeordnet sind, wobei der Behälter (22, 44) einen Schließdeckel (40) des Behälters (22, 44) umfasst, der einen geschlossenen Raum zum Lagern der Verkabelung, wenn der Generator nicht verwendet wird, bestimmt.

2. Generator nach Anspruch 1, **dadurch gekennzeichnet, dass** die Heizplatte (7) eine Umfangswand (16) aufweist, die einen Hohlraum zwischen der Wand und der thermoelektrischen Platte (15) definiert, wo die Isoliermittel (8) angeordnet sind.

3. Generator nach Anspruch 2, **dadurch gekennzeichnet, dass** die Heizplatte (7) mindestens einen mittleren Vorsprung (20) umfasst, auf welchem die thermoelektrische Platte (15) angeordnet ist.

4. Generator nach Anspruch 1, **dadurch gekennzeichnet, dass** die Isoliermittel (8) Luft sind, die die mindestens eine thermoelektrische Platte umgibt.

5. Generator nach Anspruch 1, **dadurch gekennzeichnet, dass** die Kühlmittel Wasser (26) sind.

6. Generator nach Anspruch 1, **dadurch gekennzeichnet, dass** die Kühlmittel eine Leiterplatte (30) sind, die auf den Isoliermitteln (8) und den thermoelektrischen Platten (15) angeordnet ist.

7. Generator nach Anspruch 1, **dadurch gekennzeichnet, dass** er eine wärmeleitende Silikon- oder Wachsschicht (23) umfasst, die auf der thermoelektrischen Platte (15) angeordnet ist.

8. Generator nach Anspruch 2, **dadurch gekennzeichnet, dass** er einen verformbaren Ring (24) umfasst, der aus einem feuerfesten Material besteht, der auf der Umfangswand (16) der Heizplatte (7) angeordnet ist.

9. Generator nach den Ansprüchen 2 und 8, **dadurch gekennzeichnet, dass** der verformbare Ring (24), die Isoliermittel (8) und die wärmeleitende Silikon- oder Wachsschicht (23) zwischen der Heizplatte (7) und der oberen Platte (21, 45) angeordnet sind.

10. Generator nach Anspruch 1, **dadurch gekennzeichnet, dass** er einen Aluminiumkühlkörper (2) umfasst, der eine geschliffene untere Spiegelfläche und Gitterlamellen aufweist, die auf der Anordnung angeordnet sind, die durch die Heizplatte (7), die Isoliermittel (8) und die thermoelektrischen Platten (15) gebildet ist, um die Wärme, die von der Heizplatte (7) kommt, abzuleiten.

11. Generator nach Anspruch 1, **dadurch gekennzeichnet, dass** die Kühlmittel ein Ventilator (10) sind, der mit der Verkabelung der thermoelektrischen Platten (15) verbunden ist, welcher mit derselben Spannung wie die von dem Potentialausgangsanschluss (29) erhaltene arbeitet.

12. Generator nach Anspruch 1, **dadurch gekennzeichnet, dass** die Wand des Behälters (44) mindestens ein Loch (51, 52) zum Ausgang oder Eingang der Kühlmittel (26) umfasst.

## Revendications

1. Un générateur électrique comprenant une plaque chauffante (7) transmettant de la chaleur à des moyens de refroidissement (10, 26, 30), et au moins une plaque thermoélectrique (15) disposée entre la plaque chauffante (7) et les moyens de refroidissement (10, 26, 30) dans lequel une force électromotrice générant un courant électrique est produite lorsque la plaque chauffante (7), localisée sur une source de chaleur externe, est à une température supérieure à celle des moyens de refroidissement (10, 26, 30), comprenant des moyens isolants (8) entourant l'au moins une plaque thermoélectrique (15) et disposés entre la plaque chauffante (7) et les moyens de refroidissement (10, 26, 30), dans lequel la plaque thermoélectrique (15) comprend un câblage à l'extrémité libre duquel un terminal de sortie de potentiel électrique (29) pour la sortie de potentiel électrique généré dans ladite plaque (15) est situé, ledit câblage sortant du générateur en passant par les moyens de refroidissement (26) sans être exposé à la source de chaleur externe, **caractérisé en ce que** disposée sur la plaque chauffante (7) se trouve une plaque supérieure (21, 45) formant la base inférieure d'un conteneur (22, 44) dans lequel les moyens de refroidissement (26) sont disposés, ledit conteneur (22, 44) comprenant un couvercle de fermeture (40) du conteneur (22, 44) déterminant un espace fermé pour stocker le câblage lorsque le générateur n'est pas utilisé.

2. Générateur selon la revendication 1, **caractérisé en ce que** la plaque chauffante (7) a une paroi périmétrale (16) définissant un creux entre ladite paroi et la plaque thermoélectrique (15) dans lequel les moyens isolants (8) sont disposés.

3. Le générateur selon la revendication 2, **caractérisé en ce que** la plaque chauffante (7) comprend au moins une extension centrale (20) sur laquelle la plaque thermoélectrique (15) est disposée.

4. Le générateur selon la revendication 1, **caractérisé en ce que** les moyens isolants (8) sont de l'air entourant l'au moins une plaque thermoélectrique.

5. Le générateur selon la revendication 1, **caractérisé en ce que** les moyens de refroidissement sont de l'eau (26).

6. Le générateur selon la revendication 1, **caractérisé en ce que** les moyens de refroidissement sont une plaque conductrice (30) disposée sur les moyens isolants (8) et les plaques thermoélectriques (15).

7. Le générateur selon la revendication 1, **caractérisé en ce qu'**il comprend une couche (23) en silicone ou en résine conductrice de chaleur disposée sur la plaque thermoélectrique (15).

8. Le générateur selon la revendication 2, **caractérisé en ce qu'**il comprend un anneau déformable (24) fait en matériau ignifuge disposé sur la paroi périmétrale (16) de la plaque chauffante (7).

9. Le générateur selon les revendications 2 et 8, **caractérisé en ce que** l'anneau déformable (24), les moyens isolants (8) et la couche (23) en silicone ou en résine conductrice de chaleur sont disposés entre la plaque chauffante (7) et la plaque supérieure (21, 45).

10. Le générateur selon la revendication 1, **caractérisé en ce qu'**il comprend un dissipateur (2) en aluminium ayant une surface inférieure polie en miroir et avec des grilles à ailettes disposées sur l'assemblage formé par la plaque chauffante (7), les moyens isolants (8) et les plaques thermoélectriques (15) pour évacuer la chaleur provenant de la plaque chauffante (7).

11. Le générateur selon la revendication 1, **caractérisé en ce que** les moyens de refroidissement sont un ventilateur (10) connecté au câblage des plaques thermoélectriques (15) qui opère au même voltage que celui obtenu du terminal de sortie de potentiel (29).

12. Le générateur selon la revendication 1, **caractérisé en ce que** la paroi du conteneur (44) comprend au moins un trou (51, 52) pour la sortie ou l'entrée des moyens de refroidissement (26).
